# EUROPÄISCHE PATENTSCHRIFT

(11) **EP 3 103 172 B1**
(45) Veröffentlichungstag und Bekanntmachung des Hinweises auf die Patenterteilung: **22.05.2019**
(21) Anmeldenummer: 15705902.3
(22) Anmeldetag: 28.01.2015
(51) Int. Cl.: H02B 1/30

(54) **ANREIH-SCHALTSCHRANKSYSTEM**
ELECTRICAL CABINET BAYING SYSTEM
MONTAGE EN LIGNE D'ARMOIRES ÉLECTRIQUES

(30) Priorität: 05.02.2014 DE 102014101401
(43) Veröffentlichungstag der Anmeldung: 14.12.2016
(73) Patentinhaber: RITTAL GmbH & Co. KG, 35745 Herborn (DE)
(72) Erfinder: REUTER, Wolfgang, 56479 Liebenscheid (DE); BRÜCK, Daniel, 35394 Gießen (DE)
(74) Vertreter: Angerhausen, Christoph
(86) Internationale Anmeldenummer: PCT/DE2015/100036
(87) Internationale Veröffentlichungsnummer: WO 2015/117599

(56) Entgegenhaltungen:
- EP-A1- 0 844 708
- US-A1- 2002 140 325

## Beschreibung

Die Erfindung betrifft ein Schaltschranksystem, das aus aneinandergereihten Schaltschrankeinheiten aufgebaut ist, wobei jede Schaltschrankeinheit ein Rahmengestell umfasst, das aus Rahmenprofilen aufgebaut ist, wobei zumindest die vertikalen Rahmenprofile folgende Merkmale aufweisen: Das Rahmenprofil ist bezüglich einer Querschnittsdiagonalen spiegelsymmetrisch; das Rahmenprofil weist Profilseiten auf, die Außenseiten des Rahmengestells bilden; und von den Profilseiten gehen Profilansätze aus, die sich jeweils von den Profilseiten weg erstrecken. Bei der Aneinanderreihung zweier Rahmengestelle stehen sich jeweils spiegelsymmetrisch entsprechende Profilansätze zweier Rahmenprofile gegenüber, wobei zwischen den Stirnseiten der Profilansätze ein Zwischenraum verbleibt, der durch eine Dichtung geschlossen ist, die eine auf zumindest einem der sich gegenüberstehenden Profilansätzen sitzende Aufsteckdichtung ist, die mindestens zwei einander gegenüberstehende Schenkel aufweist, zwischen denen ein Spalt verbleibt, dessen Breite kleiner oder gleich der Breite des Profilansatzes des gewählten Rahmenprofils ist. Ein derartiges Schaltschranksystem ist aus der US 2002/140325 A1 bekannt. Ein weiteres Schaltschranksystem ist aus der EP 0 844 708 A1 bekannt.

Für Schaltschränke ist die Anreihbarkeit ein wichtiges Kriterium, da dadurch die Einsatzmöglichkeiten erweitert werden. Eine anreihbare Schaltschrankeinheit kann mit weiteren derartigen Schrankeinheiten kombiniert werden und so zu einem größeren Schaltschranksystem nach Kundenwunsch zusammengefasst werden. Insbesondere kann ein solches Schaltschranksystem modular dem benötigten oder zur Verfügung stehenden Platzbedarf angepasst werden. Die Anreihbarkeit hat auch den Vorteil, dass sich Kabel und Leitungen intern über die einzelne Schaltschrankeinheit hinweg verlegen lassen. Da bei angereihten Schränken an der Verbindung die Seitenwände weggelassen werden, ist aus Stabilitätsgründen ein Rahmengestell erforderlich. Die Anreihung geschieht somit über das Rahmengestell, wobei sich das Problem der Abdichtung gegenüber dem Außenbereich bzw. der Umgebung ergibt. An der Verbindungsstelle werden daher Dichtungen eingebracht, um das Eindringen beispielsweise von Staub oder Feuchtigkeit soweit wie möglich zu unterbinden.

Ein weiteres Rahmenprofil eines Rahmengestells, das für eine anreihbare Schaltschrankeinheit ausgelegt ist, ist aus der EP 1 601 074 B1 bekannt. An der Verbindungsstelle zweier einander gegenüberstehender Rahmenprofile ist eine Strangdichtung eingefügt, die eine Dichtanordnung ergänzen soll, welche durch zwei äußere Kerne des Profils, die bündig aneinander liegen, sowie durch eine Anreihverbinderanordnung aus einem Kopplungsteil, das durch Bolzen zusammengedrückt wird, erzeugt wird. Die bekannte Anordnung ist komplex und bedingt mehrere Montageschritte.

Es ist daher die Aufgabe der Erfindung, ein Schaltschranksystem anzugeben, bei dem die Anreihung möglichst werkzeuglos vonstattengehen soll.

Diese Aufgabe wird durch ein Schaltschranksystem nach Anspruch 1 gelöst. Vorteilhafte Ausgestaltungen sind Gegenstand der Unteransprüche.

Erfindungsgemäß ist vorgesehen, dass entweder
a) der die gegenüberstehenden Schenkel der Aufsteckdichtung verbindende Steg eine Anlagefläche aufweist, die breiter ist als die Dicke des Profilansatzes des dort anzuschließenden Rahmenprofils, wobei die gegenüberstehenden Schenkel der Aufsteckdichtung eine unterschiedliche Länge oder Breite haben, oder
b) die Aufsteckdichtung im Querschnitt im Wesentlichen H-förmig ist, wobei die einander gegenüberstehenden Schenkel der Aufsteckdichtung zwischen sich einen Spalt bilden, der ausgehend von dem die Schenkel verbindenden Steg aufgeweitet ist.

Weitere Maßnahmen zur Abdichtung brauchen grundsätzlich nicht getroffen zu werden, können aber zur Stabilität der Anordnung beitragen.

Dadurch, dass die Aufsteckdichtung mindestens zwei einander gegenüberstehende Schenkel aufweist, zwischen denen ein Spalt verbleibt, dessen Breite kleiner oder gleich der Dicke des Profilansatzes des gewählten Rahmenprofils ist, wird der Profilansatz zumindest mit Reibsitz umschlossen, es kann aber auch sein, dass, wenn die Breite des Spaltes kleiner ist als die Dicke des Profilansatzes, durch geeignete Materialwahl dafür gesorgt ist, dass die Aufsteckdichtung unter einer gewissen Eigenspannung des Materials am Profilansatz anliegt.

Dadurch, dass der die gegenüberstehenden Schenkel der Aufsteckdichtung verbindende Steg einer Anlagefläche aufweist, die breiter ist als die Dicke des Profilansatzes des dort anzuschließenden Rahmenprofils, können Toleranzen ausgeglichen werden, die beim Anreihen der Schaltschrankreihen auftreten können. Wieder durch die Materialwahl kann sichergestellt werden, dass der Profilansatz des anzuschließenden Rahmenprofils in den verbindenden Steg eindringen kann, so dass nach wie vor für einen staub- bzw. feuchtigkeitsdichten Abschluss auch bei dem anzuschließenden Rahmengestell Sorge getragen wird. Diese Ausgestaltung einer Aufsteckdichtung ermöglicht es auch, ein Schaltschranksystem aus unterschiedlichen Rahmengestellen zu erzeugen. Insbesondere braucht das anzuschließende Rahmengestell keinen besonders gestalteten Profilansatz aufzuweisen.

Dadurch, dass die gegenüberstehenden Schenkel der Aufsteckdichtung eine unterschiedliche Länge haben, wird es erleichtert, die Aufsteckdichtung auf den Profilansatz des ausgewählten Rahmenprofils aufzubringen.

Dadurch, dass die einander gegenüberstehenden Schenkel der Aufsteckdichtung eine unterschiedliche Breite haben, wird das Aufbringen der Aufsteckdichtung erleichtert, da das Material bei einem der gegenüberstehenden Schenkel nachgiebiger ist.

Bei der Alternative b) kann die Länge der Schenkel der H-förmigen Dichtung an die Gegebenheiten angepasst werden, und in der Regel wird zu berücksichtigen sein, dass das werkzeuglose Aufstecken erschwert wird, wenn aufgrund der Länge der Schenkel eine erhöhte Reibungskraft zu überwinden ist. In Verbindung mit bestimmten Profilen kann es jedoch vorteilhaft sein, wenn die Länge der Schenkel der H-förmigen Dichtung in Querschnittsrichtung des Rahmenprofils im Wesentlichen der Länge der Profilansätze entspricht.

Geeignete Rahmenprofile haben beispielsweise Profilansätze, die sich senkrecht von der jeweiligen Profilseite erstrecken. Andere Ausführungsformen sind dadurch gekennzeichnet, dass sich die Profilansätze unter einem Winkel von etwa 135° zur jeweiligen Profilleiste erstrecken.

Vorzugsweise wird als Rahmenprofil ein Hohlkammerprofil mit wenigstens einer Hohlkammer verwendet, das sich durch eine gute Stabilität, insbesondere Torsionssteifigkeit, auszeichnet.

Nach einer besonderen Ausgestaltung sind zwei Hohlkammern vorhanden, die durch einen Verbindungssteg verbunden sind. Dabei kann vorgesehen sein, dass zwischen den zwei Hohlkammern angrenzend an den Verbindungssteg eine zur Querschnittsdiagonalen symmetrische Schwalbenschwanznut gebildet ist. Als Alternative kann zwischen den zwei Hohlkammern angrenzend an den Verbindungssteg eine dritte Hohlkammer gebildet sein.

Einkammrige Hohlprofile sind im Querschnitt beispielsweise rechteckig oder quadratisch. Bei einer Variante kann vorgesehen sein, dass die Profilseiten zwei ineinander übergehende Profilseitenabschnitte umfassen, die so gewinkelt sind, dass der erste Profilseitenabschnitt der ersten Profilseite senkrecht zum ersten Profilseitenabschnitt der zweiten Profilseite verläuft und der zweite Profilseitenabschnitt der ersten Profilseite parallel zum zweiten Profilseitenabschnitt der zweiten Profilseite verläuft.

Die Erfindung lässt sich zur Anreihung gleichartiger Rahmengestelle ebenso verwenden wie für Rahmengestelle, die unterschiedliche Profilgeometrien bei den vertikalen Rahmenprofilen verwenden. Auch unterschiedliche Profilgeometrien innerhalb eines Rahmengestells sind denkbar.

Es versteht sich, dass das Hohlkammerprofil mit Lochungen für Montagekomponenten zum Innenausbau des Rahmengestells bzw. der Schaltschrankeinheit versehen sind. Diese sind aber nicht Gegenstand der vorliegenden Erfindung und sollen daher nicht im Einzelnen beschrieben werden.

Die Erfindung wird im Folgenden anhand der beigefügten Zeichnung näher erläutert. Die dargestellten Profilquerschnitte bzw. Dichtungsquerschnitte sind dabei nicht notwendigerweise maßstabsgetreu dargestellt. Es zeigt:
Fig. 1a eine Querschnittsansicht eines ersten Rahmenprofils für ein Rahmengestell einer anreihbaren Schaltschrankeinheit;
Fig. 1b eine Querschnittsdarstellung aneinandergereihter Rahmenprofile nach Fig. 1a mit zwischen den Rahmenprofilen angeordneter Dichtung, welche nicht Teil der Erfindung ist;
Fig. 2a eine Querschnittsansicht eines zweiten Rahmenprofils für ein Rahmengestell einer anreihbaren Schaltschrankeinheit;
Fig. 2b eine Querschnittsdarstellung aneinandergereihter Rahmenprofile nach Fig. 2a mit zwischen den Rahmenprofilen angeordneter Dichtung, welche nicht Teil der Erfindung ist;
Fig. 3a eine Querschnittsansicht eines dritten Rahmenprofils für ein Rahmengestell einer anreihbaren Schaltschrankeinheit;
Fig. 3b eine Querschnittsdarstellung aneinandergereihter Rahmenprofile nach Fig. 3a mit zwischen den Rahmenprofilen angeordneter Dichtung, welche nicht Teil der Erfindung ist;
Fig. 4a eine Querschnittsdarstellung einer Variante einer H-förmigen Aufsteckdichtung;
Fig. 4b eine Querschnittsansicht einer Dichtung mit vergrößerter Anlagefläche; und
Fig. 4c eine Querschnittsansicht einer Dichtung, die eine Variante der Fig. 5b darstellt.

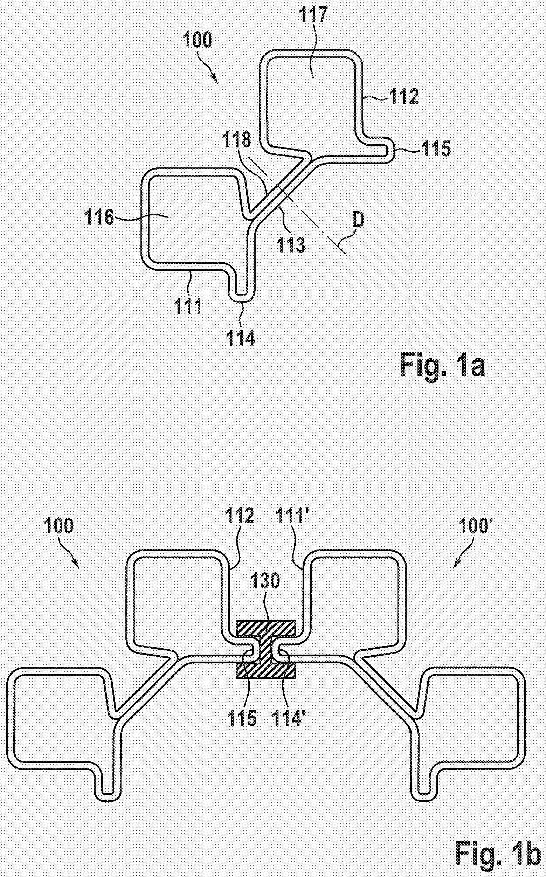

Fig. 1a zeigt eine Querschnittsdarstellung einer ersten Ausführungsform eines Rahmenprofils, das als vertikales Rahmenprofil eines Rahmengestells für eine anreihbare Schaltschrankeinheit zur Anwendung kommen kann. Dabei weist das Rahmenprofil, das als Hohlkammerprofil ausgebildet ist, zwei einander gegenüberstehende Hohlkammern 116, 117 auf, die durch einen Verbindungssteg 113 miteinander verbunden sind. Die Hohlkammern 116, 117 sind im Wesentlichen quadratisch und bilden zwischen sich angrenzend an den Verbindungssteg 113 eine zur Querschnittsdiagonalen D symmetrische Schwalbenschwanznut 118 aus. Eine der Wände 111 bzw. 112 einer Hohlkammer 116 bzw. 117 bildet dabei jeweils eine Außenseite des Rahmengestells. Von jeder dieser Profilseiten 111, 112 gehen Profilansätze 114, 115 aus, die sich jeweils von den Profilseiten 111, 112 weg erstrecken, und zwar unter einem rechten Winkel zu diesen. Die Profilansätze 114, 115 verlaufen unter einem Winkel von etwa 135° zum Verbindungssteg 113.

Fig. 1b zeigt die Anreihsituation zweier Rahmenprofile 100, 100' der Fig. la. Das Rahmenprofil 100' ist gegenüber dem Rahmenprofil 100 um 90° gedreht, so dass sie sich in einer spiegelsymmetrischen Anordnung gegenüberstehen, wobei dem Profilansatz 115 des Rahmenprofils 100 der Profilansatz 114' des Rahmenprofils 118 gegenübersteht. Auf die Profilansätze 115, 114' ist eine Aufsteckdichtung 130 gesetzt, die im Querschnitt H-förmig ist. Dabei entspricht die Länge der Schenkel der H-förmigen Dichtung 130 in Querschnittsrichtung der Rahmenprofile 100, 100' im Wesentlichen der Länge der Profilansätze 115, 114'.

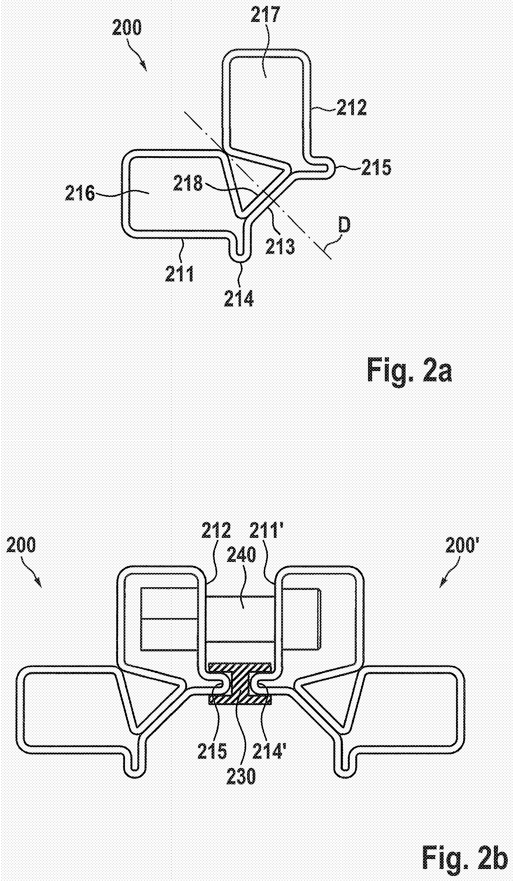

Fig. 2a zeigt eine Querschnittsansicht eines Rahmenprofils 200, das als Variante des Profils nach Fig. 1a verstanden werden kann. Wieder handelt es sich um ein Hohlkammerprofil mit zwei Hohlkammern 216, 217, die über einen Verbindungssteg 213 miteinander verbunden sind. Die Hohlkammern 216, 217 sind im Wesentlichen rechteckig und stoßen gegenüber dem Verbindungssteg 213 mit ihren Kanten aneinander, so dass eine dritte Hohlkammer 218 gebildet wird. Zwei der Wände 211 bzw. 212 der Hohlkammern 216, 217 bilden wiederum die Außenseiten des Rahmengestells, wobei sich von diesen Profilansätze 214, 215 weg erstrecken. Wie bei der Ausführungsform nach Fig. 1a verlaufen die Profilansätze 214, 215 unter einem rechten Winkel zu den Profilseiten 211, 212 und unter einem Winkel von 135° zum Verbindungssteg 13, wobei sich insgesamt eine zur Querschnittsdiagonalen D spiegelsymmetrische Ausgestaltung ergibt.

Fig. 2b zeigt die entsprechende Anreihsituation, bei der der Profilansatz 215 des Rahmenprofils 200 dem Profilansatz 214' unter Bildung eines Zwischenraums gegenübersteht, wobei dieser Zwischenraum wiederum durch eine Aufsteckdichtung 230 mit H-förmigem Querschnitt überbrückt bzw. geschlossen wird. Auch hier entspricht die Länge der Schenkel der H-förmigen Dichtung 230 in Querschnittsrichtung der Rahmenprofile 200, 200' im Wesentlichen der Länge der Profilansätze 215, 214'. Die Stabilität der Anordnung wird durch Anreihverbinder 240 erhöht, wobei in der Fig. 2b nur einer schematisch dargestellt ist. Anreihverbinder sind bekannt und werden beispielsweise durch eine Bolzen-Mutter-Anordnung gebildet.

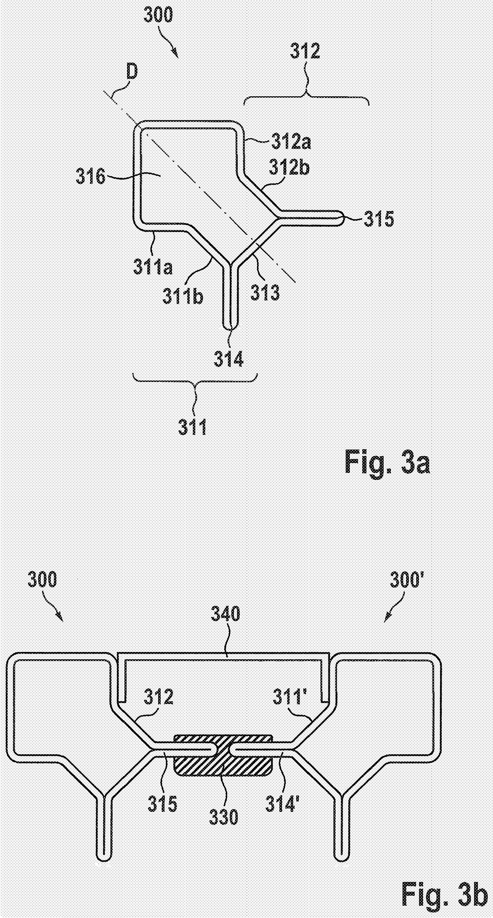

Fig. 3a zeigt eine Querschnittsansicht einer dritten Ausführungsform eines Rahmenprofils gemäß den Grundsätzen der vorliegenden Erfindung. Das Rahmenprofil 300 ist ebenfalls ein Hohlprofil, allerdings mit nur einer Hohlkammer 316. Die Profilseiten 311, 312, die die Außenseiten des Rahmengestells bilden, umfassen zwei ineinander übergehende Profilseitenabschnitte 311a, 311b bzw. 312a, 312b, die so gewinkelt sind, dass der erste Profilseitenabschnitt 311a der ersten Profilseite 311 senkrecht zum ersten Profilseitenabschnitt 312a der zweiten Profilseite 312 verläuft und der zweite Profilseitenabschnitt 311b der ersten Profilseite 311 parallel zum zweiten Profilseitenabschnitt 312b der zweiten Profilseite 312 verläuft. An den Profilseiten 311, 312 sind wiederum Profilansätze 314, 315 ausgebildet, die sich von den Profilseiten 311, 312 weg erstrecken und über einen Verbindungsabschnitt 313 miteinander verbunden sind. Unter diesem Verbindungssteg 313 verlaufen sie unter einem Winkel von etwa 135°, ebenso wie zu den jeweiligen zweiten Profilabschnitten 311b bzw. 312b der Profilseiten 311, 312. Das Rahmenprofil 300 ist wiederum symmetrisch zur Querschnittsdiagonalen D. Der Querschnitt der Hohlkammer 316 entspricht somit dem zweier teilweise übereinander gelegter Quadrate, wobei die Länge des Verbindungssteges 313 die Seitenlänge des kleineren Quadrates definiert, die gegenüber einem Quadrat mit einer größeren Seitenlänge um 45° gedreht liegt.

Fig. 3b zeigt die entsprechende Anbausituation zweier Rahmenprofile 300, 300', wobei sich die Profilansätze 315 und 314' unter Bildung eines Zwischenraumes gegenüberstehen, der durch eine Aufsteckdichtung 330 überbrückt bzw. geschlossen ist. Die Aufsteckdichtung 330 ist im Querschnitt wiederum H-förmig, wobei die einander gegenüberstehenden Beine des H-Profils, die die Profilansätze 315 und 314' umschließen, jedoch unterschiedlich ausgestaltet sind. So ist insbesondere die zum Schrankinneren weisende Seite der Dichtung 330 stärker ausgebildet als die nach außen weisende Seite, außerdem ist sie mit gerundeten Kanten versehen. Nach außen hin ist zwischen den Rahmenprofilen 300, 300' ein Anreihverbinder 340 vorgesehen, hier in Form eines Profils oder Profilstreifens mit C-förmigem Querschnitt.

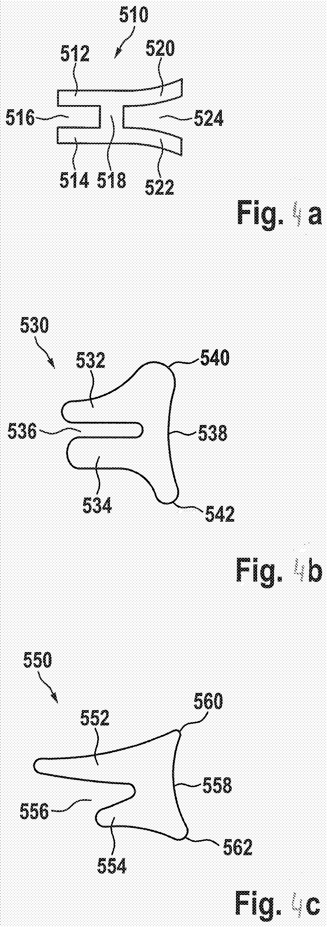

Fig. 4a zeigt eine Querschnittsansicht einer Aufsteckdichtung 510, bei der der Querschnitt im Wesentlichen H-förmig ist. Zwei einander gegenüberstehende Schenkel 512, 514 bilden zwischen sich einen Spalt 516 mit etwa rechteckigem Querschnitt, der zur nahezu passgenauen Aufnahme eines Profilansatzes eines Rahmenprofils dimensioniert ist. Die Schenkel 512, 514 sind miteinander durch einen Steg 518 verbunden, der auch die Tiefenbegrenzung für den Spalt 516 darstellt. Dem ersten Paar Schenkeln 512, 514 steht ein zweites Paar Schenkel 520, 522 gegenüber, die ebenfalls durch den Steg 518 miteinander verbunden sind und zwischen sich einen Spalt 524 ausbilden. Anders als ein Spalt 516 ist der Querschnitt des Spalts 524 nicht rechteckig, sondern weitet sich, ausgehend vom Steg 518, in Richtung nach außen auf, so dass eine sich verjüngende Aufnahmenut für das anzuschließende Rahmenprofil bzw. dessen Profilansatz gebildet wird. Da die Abmessung des Spaltes 524 am Steg 518 bzw. in dessen Nähe immer noch auf die Dicke des Profilansatzes des anzuschließenden Rahmengestells angepasst ist, ist auch hier für einen staub- und feuchtigkeitsdichten Sitz gesorgt.

Fig. 4b zeigt eine weitere Ausführungsform einer Aufsteckdichtung 530, bei der zwischen zwei einander gegenüberstehenden Schenkeln 532 und 534 ein Spalt 536 gebildet ist, dessen Breite kleiner sein kann als die Dicke des Profilansatzes, auf den die Aufsteckdichtung 530 aufgeschoben werden soll. Durch geeignete Materialwahl wird erreicht, dass die Schenkel 532, 534 den Profilansatz unter Ausnutzung der Eigenspannung des Materials fest umschließen. Der die Schenkel 532, 534 verbindende Steg erstreckt sich von einer Wulst 540 unter Bildung einer Anlagefläche 531 zur einer Wulst 542. Die Anlagefläche hat eine Breite, die größer ist als die Breite der Aufsteckdichtung 530 im Bereich der einander gegenüberstehenden Schenkel 532, 534. Durch diese Maßnahme wird einerseits dafür gesorgt, dass Toleranzen beim Aneinanderstellen anzureihender Rahmenprofile ausgeglichen werden können, andererseits eröffnet eine derartige Gestaltung einer Aufsteckdichtung 530 die Möglichkeit, ein andersartiges Profil anzuschließen. Beispielsweise kann zwischen den Schenkeln 532, 534 der Profilansatz eines Profils gemäß Fig. 3a eingesetzt werden, während sich an die Anlagefläche 538 beispielsweise der Profilansatz eines Rahmenprofils gemäß Fig. 1a anschließen kann. Die Anreihmöglichkeit ist nicht auf die in dieser Anmeldung dargestellten Rahmenprofilgestaltungen beschränkt.

Fig. 4c zeigt eine Querschnittsansicht einer weiteren Aufsteckdichtung 550, die eine Variante der Aufsteckdichtung 530 nach Fig. 4b darstellt. Dabei ist bei den einander gegenüberstehenden Schenkeln 552, 554 einer, nämlich 554, verkürzt, weist aber dennoch eine Länge auf, die die Ausbildung eines Spaltes 556 zwischen den Schenkeln 552, 554 sicherstellt. Wieder ist die vergrößerte Anlagefläche 558 vorgesehen, die sich zwischen den Wülsten 560, 562 des die Schenkel 552, 554 verbindenden Steges erstreckt. Gegenüber der Ausführungsform nach Fig. 4 ergibt sich die zusätzliche Verbesserung, dass das Aufstecken der Aufsteckdichtung 550 auf einen Profilansatz eines Rahmenprofils durch die unterschiedliche Gestaltung der Schenkel 552, 554 erleichtert wird, da hier nicht aufgeschoben werden muss, sondern das Aufbringen durch eine Kippbewegung der Aufsteckdichtung 550 gelingt.

Mit der Erfindung steht insgesamt ein Schaltschranksystem zur Verfügung, bei dem die Anbringung der Dichtung zwischen zwei anreihbaren Schaltschrankeinheiten werkzeuglos vorgenommen werden kann.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

## Patentansprüche

1. Schaltschranksystem, das aus aneinandergereihten Schaltschrankeinheiten aufgebaut ist, wobei jede Schaltschrankeinheit ein Rahmengestell umfasst, das aus Rahmenprofilen aufgebaut ist, wobei zumindest die vertikalen Rahmenprofile folgende Merkmale aufweisen:
- das Rahmenprofil (100, 100'; 200, 200'; 300, 300') ist bezüglich einer Querschnittsdiagonalen (D) spiegelsymmetrisch;
- das Rahmenprofil weist Profilseiten (111, 112; 211, 212; 311, 312) auf, die Außenseiten des Rahmengestells bilden;
- von den Profilseiten (111, 112; 211, 212; 311, 312) gehen Profilansätze (114, 115; 214, 215; 314, 315) aus, die sich jeweils von den Profilseiten (111, 112; 211, 212; 311, 312) weg erstrecken;
- bei Aneinanderreihung zweier Rahmengestelle stehen sich jeweils spiegelsymmetrisch entsprechende Profilansätze (114', 115; 214', 215; 314', 315) zweier Rahmenprofile gegenüber, wobei zwischen den Stirnseiten der Profilansätze ein Zwischenraum verbleibt, der durch eine Dichtung (510, 530, 550) geschlossen ist, die eine auf zumindest einem der sich gegenüberstehenden Profilansätzen (114', 115; 214', 215; 314', 315) sitzende Aufsteckdichtung ist, die mindestens zwei einander gegenüberstehende Schenkel (512, 514; 532, 534; 552, 554) aufweist, zwischen denen ein Spalt (516; 536; 556) verbleibt, dessen Breite kleiner oder gleich der Breite des Profilansatzes des gewählten Rahmenprofils ist, **dadurch gekennzeichnet, dass** entweder
a) der die gegenüberstehenden Schenkel (532, 534; 552, 554) der Aufsteckdichtung (530; 550) verbindende Steg eine Anlagefläche (538; 558) aufweist, die breiter ist als die Dicke des Profilansatzes des dort anzuschließenden Rahmenprofils, wobei die gegenüberstehenden Schenkel (552, 554) der Aufsteckdichtung (530;550) eine unterschiedliche Länge oder Breite haben, oder
b) die Aufsteckdichtung (510) im Querschnitt im Wesentlichen H-förmig ist, wobei die einander gegenüberstehenden Schenkel (520, 522) der Aufsteckdichtung (510) zwischen sich einen Spalt (524) bilden, der ausgehend von dem die Schenkel verbindenden Steg (518) aufgeweitet ist.

2. Schaltschranksystem nach Anspruch 1, **dadurch gekennzeichnet, dass** bei Alternative b) die Länge der Schenkel der H-förmigen Dichtung (510) in Querschnittsrichtung des Rahmenprofils im Wesentlichen der Länge der Profilansätze (114', 115; 214', 215) entspricht.

3. Schaltschranksystem nach einem der Ansprüche 1 oder 2,
**dadurch gekennzeichnet, dass** sich die Profilansätze (114, 115; 214, 215) senkrecht von der jeweiligen Profilseite (111, 112; 211, 212) erstrecken.

4. Schaltschranksystem nach einem der Ansprüche 1 bis 3, **dadurch gekennzeichnet, dass** sich die Profilansätze (314, 315) unter einem Winkel von etwa 135° zur jeweiligen Profilleiste (311, 312) erstrecken.

5. Schaltschranksystem nach Anspruch 1, **dadurch gekennzeichnet, dass** das Rahmenprofil (100, 100'; 200, 200'; 300, 300') ein Hohlkammerprofil mit wenigstens einer Hohlkammer (116, 117; 216, 217; 316) ist.

6. Schaltschranksystem nach Anspruch 6, **dadurch gekennzeichnet, dass** zwei Hohlkammern (116, 117; 216, 217) vorhanden sind, die durch einen Verbindungssteg (113; 213) verbunden sind.

7. Schaltschranksystem nach Anspruch 6, **dadurch gekennzeichnet, dass** zwischen den zwei Hohlkammern (116, 117) angrenzend an den Verbindungssteg (113) eine zur Querschnittsdiagonalen (D) symmetrische Schwalbenschwanznut (118) gebildet ist.

8. Schaltschranksystem nach Anspruch 5, **dadurch gekennzeichnet, dass** zwischen den zwei Hohlkammern (216, 217) angrenzend an den Verbindungssteg (213) eine dritte Hohlkammer (218) gebildet ist.

9. Schaltschranksystem nach Anspruch 1, **dadurch gekennzeichnet, dass** die Profilseiten (311, 312) zwei ineinander übergehende Profilseitenabschnitte (311a, 311b; 312a, 312b) umfassen, die so gewinkelt sind, dass der erste Profilseitenabschnitt (311a) der ersten Profilseite (311) senkrecht zum ersten Profilseitenabschnitt (312a) der zweiten Profilseite (312) verläuft und der zweite Profilseitenabschnitt (311b) der ersten Profilseite (311) parallel zum zweiten Profilseitenabschnitt (312b) der zweiten Profilseite (312) verläuft.

## Claims

1. A switchgear cabinet system, which is assembled from switchgear cabinet units strung together in a row, each switchgear cabinet unit comprising a rack which is made up of frame profiles, in which at least the vertical frame profiles have the following features:
the frame profile (100, 100'; 200, 200'; 300, 300') is mirror symmetrical with respect to a cross-sectional diagonal (D);
the frame profile has profile sides (111, 112; 211, 212; 311, 312) that form the outer sides of the rack;
projecting outward from the profile sides (111, 112; 211, 212; 311, 312) are profile projections (114, 115; 214, 215; 314, 315), each extending outward from one of the profile sides (111, 112; 211, 212; 311, 312);
when two racks are strung together, corresponding profile projections (114, 115; 214', 215; 314', 315) of two frame profiles are situated mirror symmetrically opposite one another in each case, leaving a gap between the end faces of the profile projections, which is closed by a seal (510, 530, 550), said seal being a push-on seal which is seated on at least one of the opposing profile projections (114', 115; 214', 215; 314', 315) and which has at least two legs (512, 514; 532, 534; 552, 554) located opposite one another, between which a gap (516; 536; 556) is formed, the width of which is less than or equal to the width of the profile projection of the selected frame profile,
**characterized in that** either
a) the bridge that connects the opposing legs (532, 534; 552, 554) of the push-on seal (530; 550) has a bearing surface (538; 558) which is wider than the thickness of the profile projection of the frame profile to be attached there, and the opposing legs (552, 554) of the push-on seal (530;550) have different lengths or widths, or
b) the push-on seal (510) is substantially H-shaped in cross-section, and between the opposing legs (520, 522) of the push-on seal (510) a gap (524) is formed, which widens starting from the bridge (518) that connects the legs.

2. The switchgear cabinet system according to claim 1, **characterized in that** with alternative b), the length of the legs of the H-shaped seal (510) in the cross-sectional direction of the frame profile corresponds substantially to the length of the profile projections (114', 115; 214', 215).

3. The switchgear cabinet system according to either of claims 1 and 2, **characterized in that** each of the profile projections (114, 115; 214, 215) extends perpendicularly from the respective profile side (111, 112; 211, 212).

4. The switchgear cabinet system according to any of claims 1 to 3, **characterized in that** each of the profile projections (314, 315) extends at an angle of approximately 135° in relation to the respective profile strip (311, 312).

5. The switchgear cabinet system according to claim 1, **characterized in that** the frame profile (100, 100'; 200, 200'; 300, 300') is a hollow profile having at least one hollow chamber (116, 117; 216, 217; 316).

6. The switchgear cabinet system according to claim 6, **characterized in that** two hollow chambers (116, 117; 216, 217) are provided, which are connected by a connecting bridge (113; 213).

7. The switchgear cabinet system according to claim 6, **characterized in that** between the two hollow chambers (116, 117), bordering the connecting bridge (113), a dovetail groove (118) is formed, which is symmetrical with respect to the cross-sectional diagonal (D).

8. The switchgear cabinet system according to claim 5, **characterized in that** between the two hollow chambers (216, 217), bordering the connecting bridge (213), a third hollow chamber (218) is formed.

9. The switchgear cabinet system according to claim 1, **characterized in that** the profile sides (311, 312) comprise two profile side segments (311a, 311b; 312a, 312b) that merge into one another and are angled such that the first profile side segment (311a) of the first profile side (311) extends perpendicular to the first profile side segment (312a) of the second profile side (312), and the second profile side segment (311b) of the first profile side (311) extends parallel to the second profile side segment (312b) of the second profile side (312).

## Revendications

1. Système d'armoire de commande qui est constitué d'unités d'armoires de commande successives, chaque unité d'armoire de commande comprenant un châssis qui est constitué de profilés de châssis, au moins les profilés de châssis verticaux présentant les caractéristiques suivantes :
- le profilé de châssis (100, 100'; 200, 200' ; 300, 300') présente une symétrie en miroir par rapport à une diagonale de section transversale (D) ;
- le profilé de châssis comprend des côtés profilés (111, 112 ; 211, 212 ; 311, 312) qui constituent les côtés externes du châssis ;
- à partir des côtés profilés (111, 112 ; 211, 212 ; 311, 312) partent des embouts profilés (114, 115 ; 214, 215 ; 314, 315) qui s'écartent chacun respectivement des côtés profilés (111, 112 ; 211, 212 ; 311, 312) ;
- lors d'une juxtaposition de deux châssis, les embouts profilés (114', 115 ; 214', 215 ; 314', 315) de deux profilés de châssis présentent entre eux une symétrie en miroir, moyennant quoi, entre les faces frontales des embouts profilés, un espace intermédiaire subsiste, qui est fermé par un joint d'étanchéité (510, 530, 550), qui est un joint d'étanchéité enfichable reposant sur au moins un des embouts profilés (114', 115 ; 214', 215 ; 314', 315) opposés, qui comprend au moins deux branches (512, 514 ; 532, 534 ; 552, 554) opposées entre elles, entre lesquelles un interstice (516 ; 536 ; 556) subsiste, dont la largeur est inférieure ou égale à la largeur de l'embout profilé du profilé de châssis choisi, **caractérisé en ce que**
a) la nervure reliant les branches opposées (532, 534 ; 552, 554) du joint d'étanchéité enfichable (530 ; 550) comprend une surface d'appui (538 ; 558) qui est plus large que l'épaisseur de l'embout profilé du profilé de châssis qui doit y être raccordé, les branches opposées (552, 554) du joint d'étanchéité enfichable (530 ; 550) présentant des longueurs ou largeurs différentes ou
b) le joint d'étanchéité enfichable (510) présente une section transversale globalement en forme de H, les branches opposées (520, 522) du joint d'étanchéité enfichable formant entre elles un interstice (524) qui s'élargit à partir de la nervure (518) reliant les branches.

2. Système d'armoires de commande selon la revendication 1, **caractérisé en ce que**, en alternative :
b) la longueur des branches du joint d'étanchéité en forme de H (510) correspond, dans la direction de la section transversale du profilé de châssis, globalement à la longueur des embouts profilés (114', 115 ; 214', 215).

3. Système d'armoires de commande selon l'une des revendications 1 ou 2, **caractérisé en ce que** les embouts profilés (114, 15; 214, 215) s'étendent perpendiculairement au côté de profilé (111, 112 ; 211, 212) correspondant.

4. Système d'armoires de commande selon l'une des revendications 1 à 3, **caractérisé en ce que** les embouts profilés (314, 315) forment un angle d'environ 135° avec la barre profilée (311, 312) correspondante.

5. Système d'armoires de commande selon la revendication 1, **caractérisé en ce que** le profilé de châssis (100, 100' ; 200, 200' ; 300, 300') est un profilé à chambres creuses avec au moins une chambre creuse (116, 117 ; 216, 217 ; 316).

6. Système d'armoires de commande selon la revendication 6, **caractérisé en ce que** deux chambres creuses (116, 117 ; 216, 217) sont présentes, qui sont reliées par une nervure de liaison (113, 213).

7. Système d'armoires de commande selon la revendication 6, **caractérisé en ce que**, entre les deux chambres creuses (116, 117), est formée, à proximité de la nervure de liaison (113), une rainure en queue d'aronde (118) symétrique par rapport la diagonale de section transversale (D).

8. Système d'armoires de commande selon la revendication 5, **caractérisé en ce que**, entre les deux chambres creuses (216, 217), à proximité de la nervure de liaison (213), est formée une troisième chambre creuse (218).

9. Système d'armoires de commande selon la revendication 1, **caractérisé en ce que** les côtés profilés (311, 312) comprennent deux portions de côtés profilés (311a, 331b ; 312a, 312b) qui présentent entre deux des angles de façon à ce que la première portion de côté profilé (311a) du premier côté profilé (311) s'étende perpendiculairement à la première portion de côté profilé (312a) du deuxième côté profilé (312) et la deuxième portion de côté profilé (311b) du premier côté profilé (311) s'étende parallèlement à la deuxième portion de côté profilé (312b) du deuxième côté profilé (312).
